Europäisches Patentamt

European Patent Office

Office européen des brevets

(11) Publication number: **0 165 057**
**B1**

## (12) EUROPEAN PATENT SPECIFICATION

(45) Date of publication of patent specification: **07.03.90**

(51) Int. Cl.⁵: **G 01 N 24/08**

(21) Application number: **85304177.0**

(22) Date of filing: **12.06.85**

---

(54) **Magnetic resonance apparatus.**

---

(30) Priority: **13.06.84 JP 121506/84**

(43) Date of publication of application:
**18.12.85 Bulletin 85/51**

(45) Publication of the grant of the patent:
**07.03.90 Bulletin 90/10**

(84) Designated Contracting States:
**DE FR NL**

(56) References cited:
**EP-A-0 107 294**
**GB-A-2 037 996**
**US-A-3 792 346**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Hino, Masaaki c/o Patent Division**
**Toshiba Corporation Principal Office**
**1-1 Shibaura 1-chome Minato-ku Tokyo (JP)**

(74) Representative: **Shindler, Nigel et al**
**BATCHELLOR, KIRK & EYLES 2 Pear Tree Court**
**Farringdon Road**
**London EC1R 0DS (GB)**

---

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a magnetic resonance (MR) apparatus for generating magnetic resonance phenomena in specific atomic nuclei in an object such as a living body, and obtaining therefrom the data reflecting at least one of the spin density distributions and relaxation time constant distributions of the specific atomic nuclei. More particularly, the invention relates to a standard signal generating device which issues a standard signal for generating a high frequency excitation pulse which is applied to the object to excite the specific atomic nuclei within the object, and also a standard signal for demodulating the detected MR signal evoked from the object.

In such an MR apparatus an object to be examined is positioned in a composite magnetic field generated by both a static magnetic field generation coil and a gradient magnetic field generation coil. High-frequency current is supplied by a transmitter to a probe-head disposed around the object, and a high-frequency magnetic field caused by the high-frequency current is applied to the object, in addition to the above described magnetic fields. Thus, an MR phenomenon is encouraged. After that, the MR signals are induced from any slice of the object and detected by the probe-head and delivered into a receiver, the output signal from which is transmitted to an amplifier to be amplified. The amplified signals are demodulated by a demodulator and delivered to a signal processor in which the spin density distribution of hydrogen atomic nuclei, the relaxation time constant distribution etc, are calculated on the basis of the demodulated signals to produce a display. In such an MR apparatus, there is a standard signal generating device for applying both transmission standard signals of the resonance frequency corresponding to the hydrogen atomic nuclei to the transmitter and receiving standard signals into the demodulator for demodulation.

During the signal acquisition process of the above described receiver, to shorten the acquisition time, the so-called multi-slice method is used, in which the resonance frequency of high frequency current is set to an amount of $f_o + \Delta f_1$ the so-called two-dimensional Fourier-transforming method, wherein phase information is employed as the best significant factor, or the like. In such a signal acquisition processes, because of the different transmission functions existing in circuit systems which compose the device, corresponding phase differentials $\Delta\theta$ are necessarily included in the detected MR signals of every circuit system. Such phase differentials $\Delta u$ bring about deterioration of the measuring precision of an MR signal since they influence the MR signal as one significant error source.

In general, resonance angular frequency $\omega_o$ is represented in accordance with the Bohr's relationship by the following formula (1):

$$\omega_o = \gamma H_o \qquad (1)$$

Wherein:

$H_o$: the intensity of a static magnetic field; and

$\gamma$: a gyromagnetic ratio.

Then if the detected MR signal of resonance frequency $\omega_o$ is demodulated with a receiving standard signal of angular frequency $\omega_r$ in the demodulator, the modulated signal is represented by the following formula (2). Furthermore, in this case, it is presumed that when a condition of $\omega_o = \omega_r$ has been set, phase differential of

$$\Delta\theta[=|(\omega_o - \omega_r)t]$$

appears in the receiving circuit system.

$$V_r \alpha m_o(X,Y,Z) \cdot \exp^{-(1/T_2{}^*+j\Delta\theta)}$$
$$= m_o(X,Y,Z) \cdot \exp^{-1/T_2{}^*} \cdot \exp^{-j\Delta\theta} \qquad (2)$$

Wherein:

$m_o(X,Y,Z)$: the density of hydrogen atomic nuclei at a co-ordinate $(X,Y,Z)$

$T_2{}^*$: the spin-spin relaxation time of an atomic nucleus influenced with the non-uniform of magnetic fields.

Up to now, in an attempt to overcome the above described problem, and to improve the measurement precision of the MR signals, the adjustment of the phase differential $\Delta\theta$ has been performed by applying the MR signals into delay-lines for example as shown in US—A—3,792,346, which are usually composed of an L—C circuit. However, some problems exist in adjustment precision and assurance since the delay-lines are analogue. Also, if the intensity of static magnetic field $H_o$ is increased to prove the performance of MR apparatus, the resonance frequency (Lamor frequency) $f_o$ also increases in proportion to the magnetic field intensity, but there is a limit to the improvement in performance even by control of the delay-lines. Furthermore, even if that control is feasible, disadvantages have been caused of enlargement of the apparatus configuration and uneconomisation. Also, even if control of the phase differentials $\Delta\theta$ is performed by the delay-lines, when the resonance frequency changes with time as the multi-slice method, it has been almost impossible to perform the phase adjustment with a high-degree precision in the wake of the frequency change.

The present invention seeks to provide an MR apparatus capable of measuring MR signals with high degree precision by being able to precisely control the phase of standard signals for generating MR phenomena as well as using in signal demodulation, in an extensive high frequency range.

Accordingly the present invention provides a magnetic resonance apparatus for generating a magnetic resonance phenomenon in an object by applying gradient and static magnetic fields and a rotating magnetic field based upon a transmission standard signal to evoke a magnetic resonance phenomenon, and detecting and demodulating the magnetic resonance signals with a reception standard signal, the apparatus comprising oscillator means (11) for generating a standard signal, and frequency control means characterised by:

memory means (17) for storing digital data corresponding to a signal of desired frequency,

read out speed controlling means (14, 15, 16) for controlling the speed at which the digital data stored in the memory means (17) is read out in accordance with the desired frequency,

read out initiation timing control means (14, 15, 16) for controlling the initiation timing of the reading out of the data stored in the memory means (17) so as to control the phase of the output signal,

digital-to-analogue converter means (18a, 18b) for producing an analogue frequency control signal from the digital output signal of the memory means;

and mixer means (19a, 19b) for controlling the frequency of the standard signal by mixing output signals from the oscillator with the said frequency control signal.

Preferred embodiments of the present invention will now be described by way of example and with reference to the accompanying drawings, wherein:

Figure 1 is a schematic block diagram illustrating the construction of an embodiment of this invention;

Figure 2 is a schematic block diagram illustrating a standard signal generating device of Figure 1;

Figure 3 is a block diagram in detail for explaining the operation of the device of Figure 2;

Figure 4 is a wave-form chart for explaining the operation of the device of Figure 2; and

Figures 5 and 6 are schematic block diagrams illustrating different embodiments each incorporating alterations, to a phase control circuit in the standard signal generating device of Figure 2.

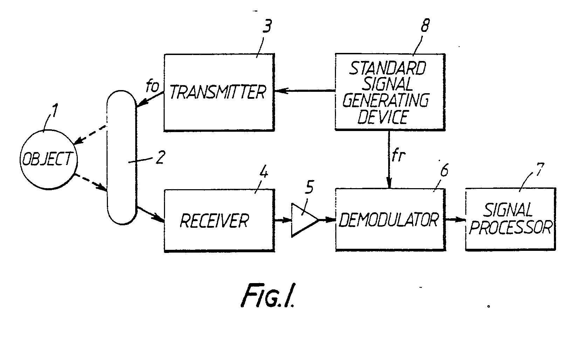

Referring to Figure 1, where the overall construction of one embodiment of the invention is illustrated, an object 1 to be examined is positioned in a composite magnetic field generated by both a static magnetic field generation coil gradient magnetic field generation coil (not shown) as is well known. High-frequency current supplied by a transmitter 3 to a probe-head 2 disposed around the object 1, produces a high-frequency magnetic field which is applied to the object 1, in combination with the above described magnetic fields, encouraging an MR phenomenon. After that, the MR signals induced from any slice of the object 1 are detected by the probe-head 2 and delivered to a receiver 4, the output signal from which is transmitted to an amplifier 5 to be amplified. The amplified signals from amplifier 5 are supplied to demodulator 6 and demodulated signals are delivered to a signal processor 7 in which the spin density distribution of hydrogen atomic nuclei, the relaxation time constant distribution etc. are calculated on the basis of the demodulated signals, to provide a display.

In addition, a standard signal generating device 8 is connected to both the transmitter 3 and demodulator 6 for applying both transmission standard signals of the resonance frequency corresponding to the hydrogen atomic nuclei to the transmitter 3, and receiving standard signals into the demodulator 6 for demodulation.

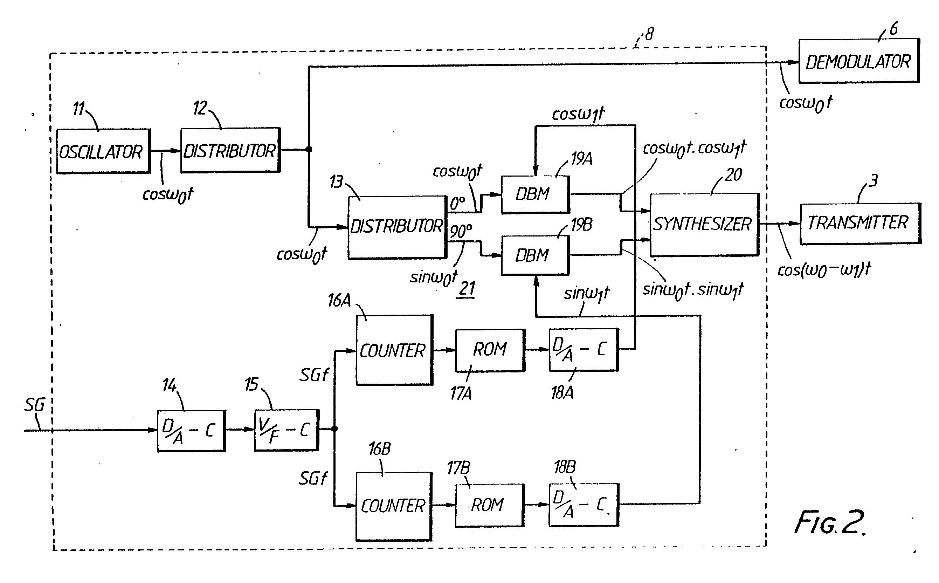

This standard signal generating device 8 is constituted as shown in Figure 2. An oscillator 11 comprising, for example, a piezocrystal element issues a high-frequency oscillation signal, $\cos \omega_o t$. This signal $\cos \omega_o t$ is delivered to a distributor 12 which, after buffering, applies the same signal, $\cos \omega_o t$, to a demodulator 6 in the reception system and a distributor 13 in the transmission system, respectively. After receiving the signal $\cos \omega_o t$, the distributor 13 outputs two signals $\cos \omega_o t$ and $\sin \omega_o t$ which have a 90° phase difference between them.

A digital-to-analogue converter 14 receives a frequency control signal SG corresponding to both the specific resonance frequency and the intensity of static magnetic field $H_o$ so as to generate an MR phenomenon for hydrogen nuclei, and then converts that signal SG into an analogue voltage signal. The above frequency control signal SG is supplied from a control device (not shown) in the MR apparatus. A voltage-to-frequency converter 15 converts the analogue frequency control signal SG, into a signal $SG_f$ of frequency according to the voltage level.

Counters 16A and 16B with preloading functions count the cycles of the signal $SG_f$, to issue the amounts of those counts. Read only memories (ROMs) 17A and 17B are connected to counters 16A and 16B to be accessed by using the count amounts as address signals. Digital data corresponding to $\cos \omega_1 t$ have been previously stored in the ROM 17A which outputs a signal of $\cos \omega_1 t$ with any frequency $\omega_1$ by reading out the data from the address of the ROM 17A determined by the address signal. Also, digital data corresponding to $\sin \omega_1 t$ have been previously stored in the ROM 17B which outputs a signal of $\sin \omega_1 t$ with any frequency $\omega_1$ by reading out the data from the address of the ROM 17B determined by the address signal.

Digital-to-analogue converters 18A and 18B convert the data read out from the ROMs 17A and 17B, respectively, to analogue data.

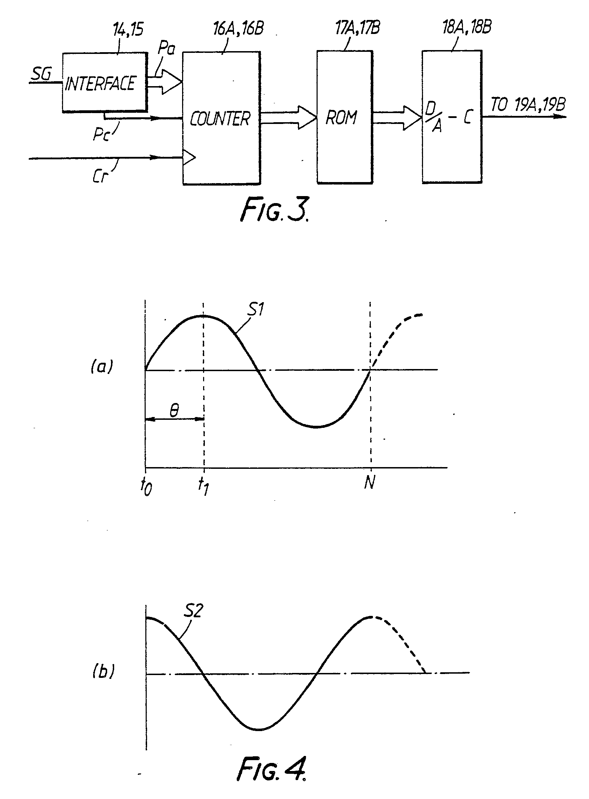

Figure 3 shows in general the operation of construction of circuit between the input terminal of the frequency control signal SG through the output terminals of the digital-to-analogue converters 18A and 18B. In Figure 3, address signals Pa for performing preload are delivered to the counters 16A and 16B from the external control interface which includes the digital-to-analogue converter 14 and the voltage-to-frequency converter 15. Preloading control signals Pc are delivered to the counters 16A and 16B from the external control interface 14 and 15, and clock signals $C_r$ are also delivered to the counters 16A and 16B.

Returning to Figure 2, double balanced mixers (DBMs) 19A and 19B combine the cosine and sine outputs from the distributor 13 with the outputs from the digital-to-analogue converters 18A and 18B, respectively. The DBM 19A receives the signal $\cos \omega_o t$ and $\cos \omega_1 t$ to be combined to issure a signal $\cos \omega_o t$ and $\sin w_1 t$.

A synthesizer 20 receives the signals $\cos \omega_o t \cdot \cos \omega_1 t$ and $\sin \omega_o t \cdot \sin \omega_1 t$ for addition to issue the following signal formula (3):

$$\cos \omega_o t \cdot \cos \omega_1 t + \sin \omega_o t \cdot \sin \omega_1 t$$
$$=1/2 \{\cos(\omega_o t + \omega_1 t) + \cos(\omega_o t - \omega_1 t)\}$$
$$+1/2 \{\cos(\omega_o t - \omega_1 t) - \cos(\omega_o t + \omega_1 t)\}$$
$$=\cos (\omega_o - \omega_1)t \qquad (3)$$

The signal $\cos(\omega_o - \omega_1)t$ represented by the above formula (3) is delivered to the transmitter 3 as a transmission standard signal.

Operation of the apparatus as constituted above will now be described. In the apparatus, since signals of the desired frequency enable data to be read out from the ROMs 17A and 17B in accordance with the specific count speeds of the counters 16A and 16B corresponding to a frequency control signal SG supplied from outside, the output frequency of the standard signal generator 8 can be altered. Therefore, the output frequency of standard signal generator 8 can be changed over extensive frequency range on the basis of the data held in ROMs 17A and 17B, and not by the output of oscillator 11.

Also, it is possible to initiate the read out of the data from the desired addresses of the ROMs 17A and 17B because the counters 16A and 16B are provided with the preloading function. For example, if data of $\cos (\omega_1 t + \theta)$ and $\sin (\omega_1 t + \theta)$ having a phase error of $\theta$ are issued, the synthesizer 20 calculates in accordance with the following formula (4) to output the signal of formula (4).

$$\cos \omega_o t \cdot \cos(\omega_1 t + \theta) + \sin \omega_o t \cdot \sin(\omega_1 t + \theta)$$
$$=1/2 \{\cos(\omega_o t + \omega_1 t + \theta) + \cos(\omega_o t - \omega_1 t - \theta)\}$$
$$+1/2 \{\cos(\omega_o t - \omega_1 t\theta) - \cos(\omega_o t + \omega_1 t\theta)\}$$
$$=\cos (\omega_o - \omega_1 t - \theta) \qquad (4)$$

The phases of outputs read out from the ROMs 17A and 17B can, therefore, be changed because the data from the desired addresses of ROMs 17A and 17B is determined by the outputs of counters 16A and 16B which have the preloading function. Accordingly, it is possible to change the phase of output from the standard signal generator 8 in the extensive high-frequency range with the data stored in the ROMs 17A and 17B, and not by the output of oscillator 11.

The precision of the above described phase control will now be explained. When the data stored in the ROMs 17A and 17B gives a wave form S1 as shown in Figure 4(a), the counters 16A and 16B are initiated at the time of $to=0$ if they have no preloading function. On the other hand, the counters 16A and 16B are initiated at the desired time t, if they have preloading function;

wave form S2 as shown in Figure 4(b) being read out from the ROMs 17A and 17B.

Now it is presumed that N is an address amount of a cycle. In this case, if address designation to the ROMs 17A and 17B can be performed with a resolution of 1 address and the wave form of a cycle is stored over N addresses, the minimum phase variable amount $\theta m$ is represented by the following formula (5):

$$\theta m = 360/N \qquad (5)$$

For example, if presuming $N=1024$, the amount $\theta m$ comes into about 0.35 degrees, namely, the phase control can be performed with a precision of better than 1 degree. The clock signals transmitted into the counters 16A and 16B should be in stable condition continuously, so that phase control can be performed most stably and precisely.

According to the apparatus described above, it is possible to control the phase of the high-frequency output signal from the standard signal generator 8 most stably and precisely, by controlling the phase of low-frequency output signals from the ROMs 17A and 17B, without directly controlling the phase of high-frequency output signal from the oscillator 8. As a result, the apparatus is suitable for offsetting the resonance frequency in the MR apparatus in a higher frequency range. Furthermore, it is efficiently applicable in case of subsequently changing the set resonance frequency by for example, a multislice method.

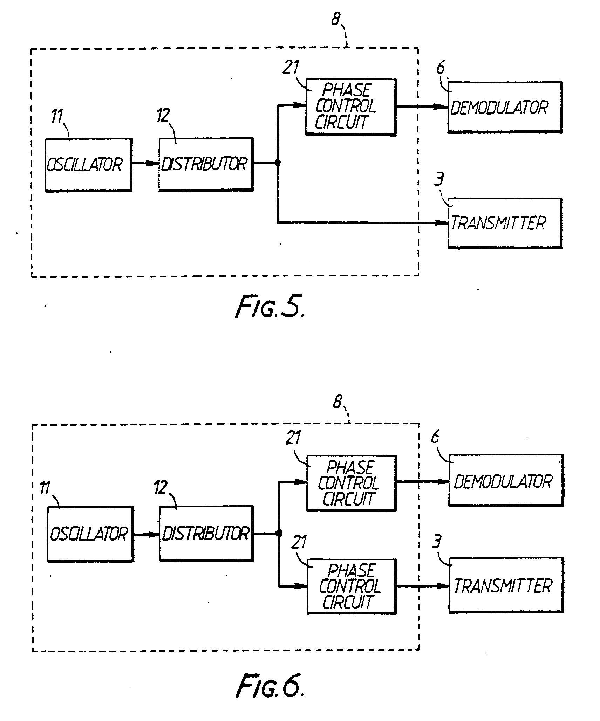

As should be apparent to those skilled in the art, modifications and variations can be made in the above described embodiments without departing from the scope of the invention. For example, the phase control circuit 2 placed in the transmission system of the above described embodiment may alternately be placed in the reception system as shown in Figure 5. A further alternative similar phase control circuit 21 may be placed in both the transmission system and reception system as shown in Figure 6.

**Claims**

1. A magnetic resonance apparatus for generating a magnetic resonance phenomenon in an object by applying gradient and static magnetic fields and a rotating magnetic field based upon a transmission standard signal to evoke a magnetic resonance phenomenon, and detecting and demodulating the magnetic resonance signals with a reception standard signal, the apparatus comprising oscillator means (11) for generating a standard signal, and frequency control means characterised by:

memory means (17) for storing digital data corresponding to a signal of desired frequency,

read out speed controlling means (14, 15, 16) for controlling the speed at which the digital data stored in the memory means (17) is read out in accordance with the desired frequency,

read out initiation timing control means (14, 15, 16) for controlling the initiation timing of the reading out of the data stored in the memory means (17), so as to control the phase of the output signal,

digital-to-analogue converter means (18a, 18b) for producing an analogue frequency control signal from the digital output signal of the memory means;

and mixer means (19a, 19b) for controlling the frequency of the standard signal by mixing output signals from the oscillator with the said frequency control signal.

2. Magnetic resonance apparatus according to claim 1 further comprising distribution means (12) for applying the standard signal to a demodulator (6) as a reception standard signal and to a further distributor (13) in the transmission system.

3. A magnetic resonance apparatus according to claim 2, in which the second distributor (13) produces two outputs which are 90° out of phase and which are supplied to the inputs of mixers (19a, 19b), a synthesizer (20) being connected to the outputs of mixers (19a, 19b) to produce a transmission standard signal.

4. A magnetic resonance apparatus as claimed in any preceding claim, wherein said read out initiation timing control means includes counters (16).

5. A magnetic resonance apparatus as claimed in claim 4, wherein said counters have preloading functions.

**Patentansprüche**

1. Magnetresonanzgerät zur Erzeugung einer magnetischen Resonanzerscheinung in einem Objekt durch Anlegen von Magnetfeldgradienten und statischen Magnetfeldern und eines magnetischen Drehfeldes, basierend auf einem Übertragungsstandardsignal, um eine magnetische Resonanzerscheinung hervorzurufen, und durch Abtasten und Demodulieren der magnetischen Resonanzsignale mit einem Empfangsstandardsignal, wobei das Gerät einen Oszillator (11) zur Erzeugung eines Standardsignales und eine Frequenzsteuereinrichtung aufweist, gekennzeichnet durch:

einen Speicher (17) zum Speichern digitaler einem Signal gewünschter Frequenz entsprechender Daten.

eine Auslesegeschwindigkeitssteureinrichtung (14, 15, 16) zum Steuern der Geschwindigkeit, mit der die im Speicher (17) gespeicherten Daten entsprechend der gewünschten Frequenz ausgelesen werden,

eine Auslesestartzeitsteuereinrichtung (14, 15, 16) zum Steuern der Startzeit des Auslesens der im Speicher (17) gespeicherten Daten, um so die Phase des Ausgangssignales zu steuern,

einen Digital/Analog-Konverter (18a, 18b) zum Erzeugen eines analogen Frequenzsteuersignales aus dem digitalen Ausgangssignal des Speichers; und

eine Mischeinrichtung (19a, 19b) zum Steuern der Frequenz des Standardsignales durch Mischen der Ausgangssignale des Oszillators mit dem Frequenzsteuersignal.

2. Magnetresonanzgerät nach Anspruch 1 mit ferner einer Verteilungseinrichtung (12) zum Anlegen des Standardsignales an einen Demodulator (6) als ein Empfangsstandardsignal und an einen weiteren Verteiler (13) im Übertragungssystem.

3. Magnetresonanzgerät nach Anspruch 2, bei dem der zweite Verteiler (13) zwei Ausgangssignale erzeugt, die 90° außer Phase sind und die den Eingängen von Mischstufen (19a, 19b) zugeführt werden, wobei ein Synthesiser (20) an die Ausgänge der Mischstufen (19a, 19b) angeschlossen ist, um ein Übertragungsstandardsignal zu erzeugen.

4. Magnetresonanzgerät nach einem der vorhergehenden Ansprüche, bei dem die Auslesestartzeit-Steuereinrichtung Zähler (16) aufweist.

5. Magnetresonanzgerät nach Anspruch 4, bei dem die Zähler Vorladefunktionen haben.

**Revendications**

1. Appareil de résonance magnétique pour engendrer une phénomène de résonance magnétique dans un corps ou dans un sujet en appliquant un champ magnétique statique et un champ magnétique à gradient, ainsi qu'un champ magnétique tournant basé sur la transmission d'un signal standard pour donner naissance à un phénomène de résonance magnétique, et poure détecter et démoduler les signaux de résonance magnétique avec un signal standard local, comprend un oscillateur (11) pour engendrer un signal standard et des moyens de réglage ou de contrôle de fréquence caractérisé par une mémoir (17) pour conserver des informations numériques correspondant à un signal ayant une fréquence donnée;

des moyens de réglage de la vitesse de lecture (14, 15, 16) pour régler ou contrôler la vitesse à laquelle les informations numériques conservées dans la mémoire (17) sont lues en fonction de la fréquence désirée;

des moyens de commande de l'initiation de la chronologie de la lecture des informations conservées dans la mémoire (17) de façon à contrôler la phase du signal de sortie;

des convertisseurs numérique/analogique (18a, 18b) pour produire un signal de commande de fréquence analogique à partir du signal de sortie de la mémoire;

et des moyens (19a, 19b) pour régler la fréquence du signal standard en mélangeant les signaux de sortie de l'oscillateur avec ledit signal de réglage ou de contrôle de fréquence.

2. Appareil de résonance magnétique nucléaire selon la revendication 1, caractérisé en ce qu'il comprend aussi des moyens de distribution (12) pour appliquer le signal standard à un distributeur (6) en tant que signal de réception standard, et à un autre distributeur (13) du système de transmission.

3. Appareil de résonance magnétique nucléaire selon la revendication 2, caracatérisé en ce que le second distributeur (13) produit deux signaux de sortie qui sont déphasés de 90° et qui sont appliqués aux entrées de deux mélangeurs (19a, 19b), un synthétiseur (20) étant connecté aux sorties des mélangeurs (19a, 19b) afin de produire un signal de transmission standard.

4. Appareil de résonance magnétique nucléaire selon l'une quelconque des revendications précédentes, caractérisé en ce que les moyens de commande qui assurent la chronométrie de l'initiation de la lecture comprennent des compteurs. (16).

5. Appareil de résonance magnétique nucléaire selon la revendication 4, caractérisé en ce que lesdits compteurs possèdent des fonctions de préchargement.

*Fig.I.*

FIG.2.

EP 0 165 057 B1

FIG.3.

FIG.4.

8

21

11   12   6

OSCILLATOR → DISTRIBUTOR

PHASE
CONTROL
CIRCUIT → DEMODULATOR

3

TRANSMITTER

FIG.5.

8

21

11   12   6

OSCILLATOR → DISTRIBUTOR

PHASE
CONTROL
CIRCUIT → DEMODULATOR

21   3

PHASE
CONTROL
CIRCUIT → TRANSMITTER

FIG.6.